# EUROPÄISCHE PATENTSCHRIFT

(11) **EP 3 553 450 B1**
(45) Veröffentlichungstag und Bekanntmachung des Hinweises auf die Patenterteilung: **26.05.2021**
(21) Anmeldenummer: 19000173.5
(22) Anmeldetag: 08.04.2019
(51) Int. Cl.: F28F 9/00, H01L 35/30, F28F 3/12, F28F 9/02, F28F 9/06, F28F 9/16, F28D 1/053, F28F 1/02

(54) **WÄRMETAUSCHER-EINHEIT**
HEAT EXCHANGER UNIT
UNITÉ D'ÉCHANGEUR DE CHALEUR

(30) Priorität: 12.04.2018 DE 102018002980
(43) Veröffentlichungstag der Anmeldung: 16.10.2019
(73) Patentinhaber: Voss Automotive GmbH, 51688 Wipperfürth (DE)
(72) Erfinder: Kolberg, Ralf, 50733 Köln (DE); Gramckow, Erik, 53757 St. Augustin (DE)
(74) Vertreter: Rebbereh, Cornelia

(56) Entgegenhaltungen:
- WO-A2-2010/112571
- DE-A1-102013 101 176
- US-A- 5 584 183

## Beschreibung

Die Erfindung betrifft eine Wärmetauscher-Einheit, umfassend zumindest ein thermoelektrisches Element, insbesondere eine Peltier-Element, zumindest ein Wärmetauscherelement zum Wärmetausch mit dem thermoelektrischen Element und zumindest ein Verteilerelement zum Zuführen und Abführen eines das zumindest eine Wärmetauscherelement durchströmenden Wärmetauschermediums.

Solche Wärmetauscher-Einheiten sind im Stand der Technik bekannt. Die Elektrifizierung von Fahrzeugen und immer umfassendere Komfortfunktionen in konventionellen Fahrzeugen mit Verbrennungsmotoren und auch Hybrid-Fahrzeugen erfordern an bislang unkritischen Stellen dezentrale Lösungen zum Bereitstellen von Wärme ebenso wie zum Wärmeentzug, also zum Kühlen. Hierfür ist es bekannt, thermoelektrische Elemente zu verwenden, um den thermoelektrischen Effekt zu nutzen. Solche thermoelektrischen Elemente sind in Form von Peltier-Elementen bekannt. Bei einem elektrischen Beaufschlagen solcher thermoelektrischen Elemente, wie von Peltier-Elementen, bilden diese eine heiße Seite und eine kalte Seite, wobei diese mit einem Wechsel der Polung ebenfalls wechselt. Um ein Kühlen zu ermöglichen, wird von der Heißseite Wärme abgeführt, um einen Temperaturunterschied zur Kaltseite zu schaffen und hierdurch ein in Bezug auf die Umgebungstemperatur des thermoelektrischen Elements niedrigeres Temperaturniveau zur Verfügung stellen zu können. Solche thermoelektrischen Elemente können insbesondere zum Temperieren von Energiespeichern verwendet werden oder auch für Temperierfunktionen von Fahrzeugkomponenten, wie einer Klimaanlage, einem Becherhalter, einer Kühlbox, einem Kühlschrank, einer Sitzheizung, einer Fahrzeuginnenraum-Kühlung oder von dezentralen Kühlelementen. Soll beispielsweise mittels eines solchen Peltier-Elements eine Kühlung eines Getränkehalters bzw. von dessen innerem thermischen Volumen vorgenommen werden, muss auf der gegenüberliegenden Seite des Peltier-Elements Wärme abgeführt werden, um eine gegenüber der Umgebung signifikant kühlere Seite als Kälte- oder Kaltseite auszubilden. Der Aufbau eines solchen im Stand der Technik bekannten Peltier-Elements ist beispielsweise in der WO 2016/050588 A1 offenbart. Derartige Peltier-Elemente weisen insbesondere eine elektrisch isolierende Ober- und Unterschicht auf, die beispielsweise aus keramischen Werkstoffen, wie Al₂O₃ besteht. Zum Temperieren unter Zuhilfenahme derartiger Peltier-Elemente sind zwei Systemansätze bekannt: Einerseits das Vorsehen eines Luft-Kühlkreislaufs und andererseits eines Flüssigkeits-Kühlkreislauf sowie einer Kopplung an einen vorhandenen Kühlkreislauf oder Chiller.

Zum Temperieren der Heißseite eines thermoelektrischen Elements ist es bekannt, einen Wärmetauscher vorzusehen. Für diesen sind unterschiedliche Ausgestaltungen bekannt, wobei nach einem Prinzip ein Kühlen mittels Luft bzw. erzwungener Konvektion vorgesehen wird, im anderen Fall ein Kühlen mittels flüssigen Mediums und eines Durchströmens des Wärmetauschers mit diesem. Im Falle des Kühlens mittels Luft bzw. erzwungener Konvektion wird das Peltier-Element an eine Wärmesenke angebunden, die durch Umströmen mit Luft, beispielsweise vermittels eines sich drehenden Lüfterelements, einen konstanten Luftstrom mit niedriger Umgebungstemperatur vorsieht und somit einen Wärmestrom von der Kaltseite zur Heißseite des Peltier-Elements ermöglicht, um die Kaltseite unter der jeweiligen Umgebungstemperatur zu halten.

Beispielsweise sind Flüssigkeits-Wärmetauscher der Firma Lytron Inc., Woburn, USA, bekannt, bei denen ein Aluminium-Extrusionsprofil und angelötete Verteilerelemente als Ein- und Auslaufbereich für das flüssige Wärmetauschermedium vorgesehen sind. Die Integration eines endseitigen Anschlussprofils zum Anschließen einer Medienleitung an einen solchen Flüssigkeits-Wärmetauscher erweist sich als sehr aufwendig, da dieses entweder an die Verteilerelemente angeformt oder angelötet werden muss. Durch die Verwendung von Aluminium erweisen sich die Ein- und Auslaufbereiche, somit die angelöteten Verteilerelemente, als zusätzliche Wärmeverlustflächen, da in diesen ein hoher Grad an Wärmeverlusten auftritt. Um eine kraftschlüssige Verbindung zu einem Peltier-Element vorzusehen, erfolgt diese über ein Verschrauben, so dass es erforderlich ist, hier ein zusätzliches Bauteil einzubringen, was einerseits einen erhöhten Aufwand bedeutet und andererseits ein größeres Bauvolumen und höhere Kosten mit sich bringt. Mittels der Verteilerelemente in Form von Ein- und Auslaufbereichen aus Aluminium ist es bei der Lösung nach Lytron kaum möglich, eine gleichmäßige Strömungsverteilung in Ein- und Auslaufbereich des Flüssigkeits-Wärmetauschers vorzusehen, bedingt durch die seitlich an dem Extrusionsprofil des Flüssigkeits-Wärmetauschers angebrachten Aluminiumrohre des Ein- und Auslaufbereichs, somit der beiden Verteilerelemente des Flüssigkeits-Wärmetauschers. Die US 5,584,183 A offenbart einen thermoelektrischen Wärmetauscher mit einer Reihe von thermoelektrischen Einheiten, die zwischen zwei Kanälen angeordnet sind. Die thermoelektrischen Einheiten übertragen Wärme von einer Kühlflüssigkeit, die durch einen Kanal strömt, zu einer zweiten Flüssigkeit, die durch einen anderen Kanal strömt. Eine gleichmäßige Verteilung des durch die Kanäle strömenden Mediums wird durch Verwenden einer Mediumverteileinrichtung erreicht. Die Mediumverteileinrichtung verteilt die Medien, die in den Wärmetauscher einströmen, ohne Verursachen eines großen Druckverlustes. Der Wärmetauscher wird zum Verbessern des thermischen Kontakts zwischen den thermoelektrischen Einheiten und den Kanälen zusammengehalten bzw. geklammert, wobei hierfür eine Lastverteilauflage, Federn und Bolzen verwendet werden.

Es wäre daher wünschenswert, einen besonders guten Wärmeübergang vom thermoelektrischen Element, insbesondere Peltier-Element, zum Wärmetauscherelement vorzusehen unter Vermeiden lokaler Temperaturspitzen an der Anbindungsfläche des Wärmetauscherelements zum thermoelektrischen Element, insbesondere Peltier-Element. Wünschenswert wäre insbesondere eine sehr gute Wärmeleitfähigkeit im Bereich des Wärmeübergangs von der Heißseite des thermoelektrischen Elements, insbesondere Peltier-Elements, zum Wärmetauscherfluid bzw -medium, das das Wärmetauscherelement durchströmt. Der vorliegenden Erfindung liegt daher die Aufgabe zugrunde, eine Wärmetauscher-Einheit, umfassend zumindest ein thermoelektrisches Element, insbesondere ein Peltier-Element, zumindest ein Wärmetauscherelement zum Wärmetausch mit dem thermoelektrischen Element und zumindest ein Verteilerelement zum Zuführen und Abführen eines das zumindest eine Wärmetauscherelement durchströmenden Wärmetauschermediums, vorzusehen, bei der eine flächige Verbindung von thermoelektrischem Element und Wärmetauscherelement unter Vermeiden lokaler Temperaturspitzen an der Anbindungsfläche des thermoelektrischen Elements zum Wärmetauscherelement und unter Sicherstellen eines stabilen Verbundes des thermoelektrischen Elements mit dem Wärmetauscherelement vorgesehen wird.

Die Aufgabe wird nach dem Oberbergriff des Anspruchs 1 dadurch gelöst, dass zumindest ein Halterahmen zum Halten zumindest des zumindest einen Wärmetauscherelements und des zumindest einen thermoelektrischen Elements vorgesehen ist, wobei das zumindest eine Verteilerelement mit dem zumindest einen Wärmetauscherelement und mit dem zumindest einen Halterahmen verbindbar oder verbunden ist. Weiterbildungen der Erfindung sind in den abhängigen Ansprüchen definiert.

Dadurch wird eine Wärmetauscher-Einheit geschaffen, die zumindest ein thermoelektrisches Element, wie z.B. ein Peltier-Element, zumindest ein Wärmetauscherelement zum Wärmetausch mit dem thermoelektrischen Element und zumindest ein Verteilerelement zum Zuführen und Abführen eines das zumindest eine Wärmetauscherelement durchströmenden Wärmetauschermediums, insbesondere eines flüssigen Wärmetauschermediums, umfasst. Zumindest ein Halterahmen hält das thermoelektrische Element und das Wärmetauscherelement. Zum Zu- und Abführen von Wärmetauschermedium wird/ist zumindest ein Verteilerelement mit dem Wärmetauscherelement und mit dem zumindest einen Halterahmen verbunden. Durch das Vorsehen des Halterahmens zum Halten von thermoelektrischem Element und Wärmetauscherelement kann eine flächige Verbindung von thermoelektrischem Element und Wärmetauscherelement geschaffen werden. Ebenfalls ist hierdurch eine Bauraumoptimierung des Aufbaus der Wärmetauscher-Einheit möglich. Durch das Halten des thermoelektrischen Elements und des Wärmetauscherelements durch den Halterahmen können beide miteinander sicher kraftschlüssig verbunden werden. Das thermoelektrische Element kann auf einer Außenseite des Wärmetauscherelements und der zumindest eine Halterahmen auf der gegenüberliegenden Seite angeordnet sein. Ebenfalls ist es möglich, dass das thermoelektrische Element zwischen Wärmetauscherelement und dem zumindest einen Halterahmen angeordnet ist/wird. Durch das Vorsehen des stabilen Halterahmens wird eine Steifigkeit geschaffen, die es ermöglicht, das vergleichsweise filigrane Wärmetauscherelement derart zu stabilisieren, dass das thermoelektrische Element auf diesem stets flächig aufliegt. Lokale Temperaturspitzen an der Anbindungsfläche des Wärmetauscherelements zum thermoelektrischen Element können hierbei ebenfalls vermieden werden. Es können somit Beschädigungen am thermoelektrischen Element und Wärmetauscherelement sicher vermieden werden.

Das Wärmetauscherelement besteht vorteilhaft aus einem Werkstoff mit sehr hoher Wärmeleitfähigkeit, wie insbesondere aus Aluminium, um einen besonders guten Wärmeübergang der von dem thermoelektrischen Element erzeugten Wärme an das Wärmetauschermedium zu ermöglichen. Besonders bevorzugt ist das Wärmetauscherelement als Strangpressprofil aus Aluminium ausgebildet. Hierdurch wird eine sehr gute Wärmeleitfähigkeit auch bei geringen Volumenströmen, somit laminarer Strömung, innerhalb von Strömungskanälen für das Wärmetauschermedium, die innerhalb des Wärmetauscherelements ausgebildet sind, ermöglicht. Beispielsweise kann das Wärmetauscherelement als Aluminium-Strangpressprofil mit einer Breite von 25 bis 70 mm und einer Höhe von 1,5 bis 3 mm mit 4 bis 40 Kanälen zum Durchströmen mit Wärmetauschermedium, insbesondere flüssigem Wärmetauschermedium, vorgesehen werden. Hierdurch ist somit eine sehr gute Wärmeleitfähigkeit im Bereich des Wärmeübergangs von der Heißseite des thermoelektrischen Elements zum Wärmetauscherfluid bzw. -medium, das das Wärmetauscherelement durchströmt, möglich.

Weiter vorteilhaft ist der Halterahmen als Rippenstruktur ausgebildet. Hierdurch ist es möglich, ein geringes Bauteilgewicht für den Halterahmen vorzusehen, wobei dieser zugleich für die Verbindung von thermoelektrischem Element und Wärmetauscherelement eine hohe Stabilität ermöglicht. Der Halterahmen kann vorteilhaft aus zumindest einem hoch kriechbeständigen Kunststoffmaterial zur Gewichtsminimierung und Sicherstellung einer Kraftübertragung beim Verbinden mit dem thermoelektrischen Element bestehen. Insbesondere kann der Halterahmen aus zumindest einem glas- oder kohlefasergefüllten Thermoplasten oder Duroplasten bestehen. Beispielsweise kommen als glas- oder kohlefasergefüllte Thermoplaste Polypropylen (PP), Polyamid (PA), Polyoxymethylen (POM) oder Polyphthalamid, bei der Ausbildung aus einem Duroplast beispielsweise glasfasergefüllte Phenolformmasse in Frage. Ein solcher Halterahmen kann auch eine Kraftübertragung beim Verbinden des Halterahmens mit dem thermoelektrischen Element beispielsweise durch Verschrauben sicherstellen. Die Zwischenräume zwischen den Rippen der Rippenstruktur des Halterahmens können thermisch isoliert werden, um dort Wärmeverluste zu vermeiden. Sofern das thermoelektrische Element zwischen Halterahmen und Wärmetauscherelement angeordnet ist, kann auf der dem thermoelektrischen Element gegenüberliegenden Seite des Wärmetauscherelements zumindest eine Isoliereinrichtung vorgesehen werden. Insbesondere kann eine solche Isoliereinrichtung kappenartig ausgebildet und am Halterahmen befestigt sein oder werden.

Weiter vorteilhaft kann das zumindest eine Verteilerelement endseitig mit zumindest einem Anschlussprofil zum Anschließen an zumindest eine Medienleitung versehen sein. Über eine solche Medienleitung wird Wärmetauschermedium dem Verteilerelement und dementsprechend dem Wärmetauscherelement der Wärmetauscher-Einheit zugeführt bzw. von dieser auch wieder abgeführt. Das Anschlussprofil kann nach Art eines Dornprofils, nach Art eines sogenannten Quickconnector-Profils oder eines sonstigen Anschlussprofils zum Anschließen einer Medienleitung ausgebildet sein. Vorteilhaft besteht das zumindest eine Verteilerelement aus zumindest einem Material aus geringer Wärmeleitfähigkeit zum Minimieren von Wärmeverlusten insbesondere aus zumindest einem thermoplastischen Kunststoffmaterial. Durch das Ausbilden des zumindest einen Verteilerelements, das dem Ein- und Auslauf bzw. Zu- und Ablauf von Wärmetauschermedium zu bzw. von dem Wärmetauscherelement dient, aus einem thermoplastischen Kunststoffmaterial, das eine geringe Wärmeleitfähigkeit aufweist, wird ermöglicht, dass im Bereich des zumindest einen Verteilerelements lediglich geringe Wärmeverluste auftreten. Gerade im Unterschied zum Stand der Technik der von der Firma Lytron angebotenen Flüssigkeits-Wärmetauscher, bei denen der Ein- und Auslaufbereich für Wärmetauschermedium aus Aluminium besteht, so dass dort große Wärmeverluste auftreten, können beim Vorsehen des zumindest einen Verteilerelementes aus thermoplastischem Kunststoffmaterial die Wärmeverluste, die dort auftreten, soweit wie möglich minimiert werden. Als Werkstoffe kommen für das zumindest eine Verteilerelement insbesondere glas- oder kohlefasergefüllte Thermoplaste in Frage, beispielsweise Polyoxymethylen (POM), Polypropylen (PP) oder Polyphthalamid (PPA), wobei diese eine gute Beständigkeit gegen Wasser und Glykol bei einer guten Formstabilität aufweisen, somit für das Durchströmen mit Wärmetauschermedium gut geeignet sind.

Weiter vorteilhaft ist das zumindest eine Verteilerelement mit dem zumindest einen Halterahmen durch eine formschlüssige Verbindung verbindbar und verbunden. Insbesondere kann ein formschlüssiges Verbinden durch Heißnieten und/oder Verrasten erfolgen. Bei Vorsehen eines Heißnietverfahrens ist kein Stoffschluss zwischen Halterahmen und Verteilerelement erforderlich. Hierbei wird ferner eine Doppelpassung vermieden, da das Verteilerelement eben flächig/planar am Halterahmen anliegt und somit auch bei Auftreten einer Innendruckbelastung im Verteilerelement durch das dort hindurchströmende Wärmetauschermedium gegen ein Verdrehen bzw. Verschieben gesichert ist. Ein für die Heißvernietung vorgesehener Stift, insbesondere am Halterahmen, weist einen geringeren Außendurchmesser als eine in dem anderen Bauteil, wie dem Verteilerelement, vorgesehene Bohrung bzw. Öffnung auf. Ein Formschluss wird durch Aufschmelzen des Stiftes, Einschmelzen von dessen Material in die Bohrung und Ausfüllen der konischen Bohrungsgeometrie erzeugt. Es kann somit auf einfache und effiziente Art und Weise eine formschlüssige Verbindung von Halterahmen und Verteilerelement geschaffen werden. Beide können aus unterschiedlichen Materialien bestehen, so dass ein Optimum sowohl bezüglich Rohstoffkosten als auch bezüglich der Bauteilanforderungen erzielt werden kann. Vorteilhaft ist der zumindest eine für das Heißvernieten vorgesehene Stift im Bereich der oder auf der (gedachten) Mittelachse des Bauteils, insbesondere des Halterahmens, angeordnet, um das Einleiten eines Drehmoments aufgrund der Innendruckbelastung der Verteilerelemente zu vermeiden.

Neben dem Heißvernieten können Verteilerelement und Halterahmen auch durch Vorsehen zumindest einer Verrastung miteinander verbunden werden. Diese kann beispielsweise nach Art eines Schnapphakens ausgebildet sein. Hakenförmige Elemente, die insbesondere am Halterahmen angeformt sind, können an entsprechenden Flächen des zumindest einen Verteilerelements verrasten.

Weiter vorteilhaft können die an dem zumindest einen Halterrahmen angeordneten Verteilerelemente als Gleichteil ausgebildet und mit dem Halterahmen verbunden sein bzw. werden zum Vorsehen eines Wärmetauschermedium-Einlaufs und eines Wärmetauschermedium-Auslaufs. Somit werden Ein- und Auslaufbereich nicht durch unterschiedlich gestaltete Verteilerelemente gebildet, sondern durch als Gleichteile ausgebildete Verteilerelemente, die entsprechend an dem Halterahmen montiert werden. Diese können dementsprechend in unterschiedliche Richtungen weisen oder auch in dieselbe Richtung. Durch die Ausgestaltung als Gleichteile können Kosten vergleichsweise gering gehalten und ferner eine Anpassung an den vorhandenen Bauraum besonders gut erzielt werden. Es ist eine flexible Anpassung an unterschiedlichste Bauräume hierüber möglich. Die jeweiligen als Ein- bzw. Auslauf dienenden Verteilerelemente werden in der gewünschten passenden Ausrichtung am Halterahmen angebracht, um eine flexible Anpassung an den jeweils zur Verfügung stehenden Bauraum vorzunehmen.

Das zumindest eine Wärmetauscherelement kann ferner durch Vorsehen zumindest eines Dichtelements, insbesondere eines radial wirkenden Dichtelements, gegenüber dem zumindest einen Verteilerelement abgedichtet werden oder sein. Um im Bereich der Verbindungsstelle von Wärmetauscherelement und Verteilerelement den ungewollten Austritt von Wärmetauschermedium zu vermeiden, erweist es sich als besonders vorteilhaft, eine radial wirkende Elastomer-Dichtung dort anzuordnen. Alternativ kann das zumindest eine Verteilerelement aus Kunststoffmaterial an das Aluminium-Strangpressprofil des zumindest einen Wärmetauscherelements angespritzt, angeklebt oder mit diesem heißverstemmt werden. Bei einem Heißverstemmen wird üblicherweise das Aluminium des Wärmetauscherelements in dem Bereich, in dem das Heißverstemmen vorgenommen werden soll, aufgeraut, um das Verbinden bzw. Verstemmen zu unterstützen. Ein Verkleben von Verteilerelement und Wärmetauscherelement aus Aluminium eignet sich besonders beim Ausbilden des zumindest einen Verteilerelements aus Polyamid.

Das zumindest eine Verteilerelement weist weiter vorteilhaft zumindest ein Anschlagselement zum Vorsehen eines Anschlags bei der Positionierung des thermoelektrischen Elements an diesem auf. Hierdurch ist es möglich, das thermoelektrische Element, insbesondere Peltier-Element, optimal im Verteilerelement zu positionieren, da dieses seitlich gegen das Anschlagselement angelegt wird und somit bezüglich der Positionierung im Verteilerelement optimal liegt. Grundsätzlich ist es selbstverständlich ebenfalls möglich, das zumindest eine Verteilerelement ohne ein solches Anschlagselement auszubilden, z.B. wenn eine andere Art einer Positionierhilfe für das zumindest eine thermoelektrische Element verwendet wird oder, wenn z.B. eine ordnungsgemäße Positionierung des zumindest einen thermoelektrischen Elements im zumindest einen Verteilerelement auch ohne ein solches Anschlagselement oder eine andere Art einer Positionierhilfe möglich ist oder gewünscht wird.

Der zumindest eine Halterahmen kann ferner mit zumindest einer Halterungs- und/oder Führungseinrichtung zum Halten und/oder Führen zumindest einer elektrischen Zuleitung des thermoelektrischen Elements versehen sein. Hierdurch ist es möglich, elektrische Zuleitungen des thermoelektrischen Elementes, Peltier-Elements, am Halterahmen sicher zu halten und zu führen, so dass auch beim Einbau der Wärmetauscher-Einheit beispielsweise in ein Fahrzeug die elektrischen Zuleitungen des thermoelektrischen Elements gegen eine Beschädigung zumindest im Bereich der Wärmetauscher-Einheit geschützt werden können.

Als weiter vorteilhaft erweist es sich, das zumindest eine Verteilerelement mit zumindest einer Einrichtung zur Strömungssteuerung zu versehen zum Steuern der Strömung des Wärmetauschermediums in Kanäle des Wärmetauscherelements hinein und aus diesen hinaus in das zumindest eine Verteilerelement hinein. Durch das Vorsehen zumindest einer solchen Einrichtung zur Strömungssteuerung kann das Wärmetauschermedium optimal auf Kanäle des Wärmetauscherelements verteilt werden. Gerade durch das Ausbilden des zumindest einen Verteilerelements aus Kunststoffmaterial lassen sich derartige Einrichtungen zur Strömungssteuerung auf einfache Art und Weise in dieses integrieren. Beispielsweise können solche Einrichtungen zur Strömungssteuerung in Form von Stegen, Staubalken etc. ausgebildet und im Strömungsquerschnitt des zumindest einen Verteilerelements, insbesondere im sonst kreisrunden Ein- und Auslaufquerschnitt von diesen, angeordnet werden, um hierüber die Strömung der Wärmetauschermediums optimal steuern zu können. Hierdurch ist somit eine homogene Verteilung des Wärmetauschermediumstroms von dem Querschnitt des zumindest einen Verteilerelements auf die einzelnen Kanäle des Wärmetauscherelementes möglich.

Das zumindest eine Verteilerelement kann zum Verbinden mit mehr als einem Wärmetauscherelement ausgebildet sein, insbesondere zumindest ein Abgang bzw. Abzweig im Strömungsquerschnitt des Verteilerelements vorgesehen sein, um ein weiteres Wärmetauscherelement zu speisen. Aufgrund des modularen Aufbaus der Wärmetauscher-Einheit können somit nicht nur ein Wärmetauscherelement mit einem thermoelektrischen Element verbunden werden, sondern auch mehrere Wärmetauscherelemente mit einem oder mehreren thermoelektrischen Elementen bzw. mehrere thermoelektrische Elemente mit einem oder mehreren Wärmetauscherelementen.

Durch das Ausbilden des zumindest einen Verteilerelements der Wärmetauscher-Einheit aus thermoplastischem Kunststoff mit geringer Wärmeleitfähigkeit, somit des Ein- und Auslaufbereichs des Wärmetauschermediums in und aus dem Wärmetauscherelement der Wärmetauscher-Einheit, ist eine Isolation dieses Bereichs und somit eine Vermeidung von Wärmeverlusten, wie beispielsweise in einen Fahrzeuginnenraum eines Fahrzeugs hinein, in dem die Wärmetauscher-Einheit angeordnet ist, möglich. Lokale Temperaturspitzen im Bereich der Anbindungsfläche des Wärmetauscherelements zum thermoelektrischen Element können durch das Vorsehen des Halterahmens in Verbindung mit dem zumindest einen Verteilerelement vermieden und hierbei zugleich eine hohe Steifigkeit des Wärmetauscherelements, das vorteilhaft als Aluminiumprofil ausgebildet ist, welches eine Anzahl von durch Wärmetauschermedium durchströmbaren Kanälen aufweist, erzielt werden. Durch die Ausbildung des Wärmetauscherelements aus Aluminium kann nicht nur eine kompakte Bauweise von diesem sichergestellt werden mit einer hohen Anzahl an darin angeordneten Kanälen, sondern hierüber ebenso eine gute Wärmeleitfähigkeit auch bei geringen Volumenströmen, somit bei laminarer Strömung, geschaffen werden. Durch das Vorsehen des Halterahmens in Verbindung mit dem zumindest einen Verteilerelement und dem Befestigen des thermoelektrischen Elements an dem Halterahmen sowie des Wärmetauscherelementes an den zumindest einen Verteilerelement wird ein kraftschlüssiger Verbund der Wärmequelle des thermoelektrischen Elementes und des Wärmetauscherelementes sichergestellt. Hierbei besteht entsprechend auch eine sehr gute Wärmeleitfähigkeit im Bereich des Wärmeübergangs von dem thermoelektrischen Element bzw. dessen Heißseite zum Wärmetauschermedium, das die Kanäle des Wärmetauscherelementes durchströmt. Das thermoelektrische Element und das Wärmetauscherelement sind flächig miteinander verbunden, so dass auch ein bauraumoptimierter Aufbau erzeugt werden kann. Durch die Integration der Anschlussprofile zum Anschließen von Medienleitungen an das zumindest eine Verteilerelement der Wärmetauscher-Einheit wird ebenfalls eine Bauraumoptimierung und zugleich eine gute Anbindungsmöglichkeit an eine Medienleitung bzw. von Medienleitungen ohne zusätzliche Komponenten geschaffen und somit auch ein vergleichsweise geringes Gewicht der Wärmetauscher-Einheit erzielt. Durch das Vorsehen eines Wärmetauscherelementes als Aluminium-Strangpressprofil ist auch bei geringen Volumenströmen und somit laminarer Strömung ein sehr guter Wärmeübergang von dem thermoelektrischen Element auf das durch das Wärmetauscherelement strömende Wärmetauschermedium möglich. Ein solches Wärmetauscherelement nimmt lediglich einen geringen Bauraum ein und kann kostengünstig in Serie gefertigt werden.

Zur näheren Erläuterung der Erfindung werden im Folgenden Ausführungsbeispiele von dieser näher anhand der Zeichnungen beschrieben. Diese zeigen in:
- Figur 1: eine Draufsicht auf eine erste Ausführungsform einer erfindungsgemäßen Wärmetauscher-Einheit mit Halterahmen und zwei Verteilerelementen sowie Wärmetauscherelementen und darunter angeordnetem thermoelektrischem Element,
- Figur 1a: eine Querschnittsansicht entlang der Linie A-A der Wärmetauscher-Einheit gemäß Figur 1,
- Figur 2: eine perspektivische Ansicht eines erfindungsgemäßen Verteilerelements gemäß Figur 1,
- Figur 3a und 3b: Detailschnittansichten des Vorgangs des Heißvernietens eines erfindungsgemäßen Verteilerelements und eines erfindungsgemäßen Halterahmens einer erfindungsgemäßen Wärmetauscher-Einheit vor dem Heißvernietvorgang (Figur 3a) und nach dem Heißvernietvorgang (3b),
- Figur 4: eine perspektivischen Ansicht einer erfindungsgemäßen Klebeverbindung von erfindungsgemäßem Verteilerelement und erfindungsgemäßem Wärmetauscherelement einer erfindungsgemäßen Wärmetauscher-Einheit,
- Figur 5: eine perspektivische Detail-Draufsicht auf eine erfindungsgemäße Wärmetauscher-Einheit im Bereich einer Schnapphakenverbindung von erfindungsgemäßem Halterahmen und erfindungsgemäßem Verteilerelement der Wärmetauscher-Einheit, und
- Figur 6: eine Querschnittsansicht durch eine alternative Ausführungsform eines erfindungsgemäßen Verteilerelementes mit Dichtungselement und Wärmetauscherelement sowie Anschlagselement für ein thermoelektrisches Element.

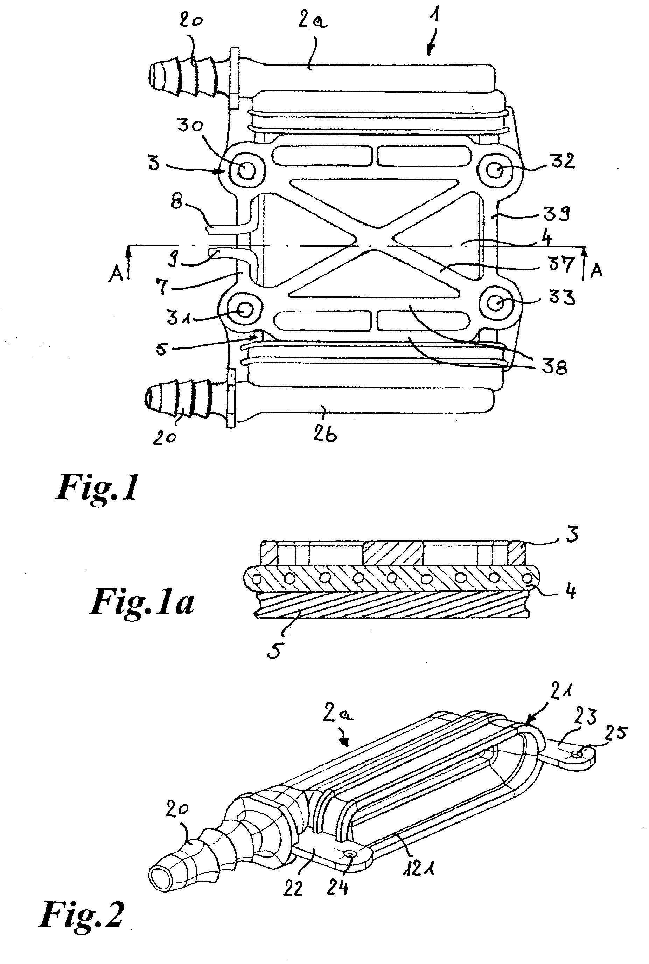

Figur 1 zeigt eine Draufsicht auf eine Wärmetauscher-Einheit 1. Diese umfasst zwei Verteilerelemente 2, die hier zur Unterscheidung mit den Bezugszeichen 2a und 2b bezeichnet sind, sowie einen zwischen diesen angeordneten Halterahmen 3. Der Halterahmen 3 ist als Rippenstruktur aufgebaut und dient dem Befestigen eines Wärmetauscherelementes 4 und eines flächig auf diesem angeordneten thermoelektrischen Element 5. Das thermoelektrische Element ist insbesondere als Peltier-Element ausgebildet. In der Querschnittsansicht gemäß Figur 1a ist erkennbar, dass das thermoelektrische Element 5 benachbart zu dem Wärmetauscherelement 4 angeordnet ist und flächig an diesem anliegt und das Wärmetauscherelement 4 an dem Halterahmen 3 anliegt, somit zwischen Halterahmen 3 und thermoelektrischem Element 5 angeordnet ist.

Der als Rippenstruktur aufgebaute Halterahmen 3 weist randseitig Öffnungen 30, 31, 32, 33 auf, die zum Befestigen der Wärmetauscher-Einheit 1 beispielsweise in einem Fahrzeug dienen. Diese Öffnungen sind jeweils mit Material des Halterahmens rosettenartig umrandet und weisen untereinander Verbindungsstege in diagonaler (37) und in Längsrichtung (38) sowie Querrichtung (39) des Halterahmens auf. Hierdurch wird eine stabile und zugleich leichte Struktur für den Halterahmen 3 vorgesehen. Dieser besteht insbesondere aus einem hoch kriechbeständigen Kunststoff, um das Gewicht des Halterahmens noch weiter reduzieren zu können. Als Materialien eignen sich hierbei beispielsweise glas- oder kohlefasergefüllte Thermoplaste, wie beispielsweise PP, PA, PDM oder PPA. Ebenfalls ist es möglich, den Halterahmen, zumindest teilweise, aus Duroplasten herzustellen, wie beispielsweise glasfasergefüllten Phenolformmassen.

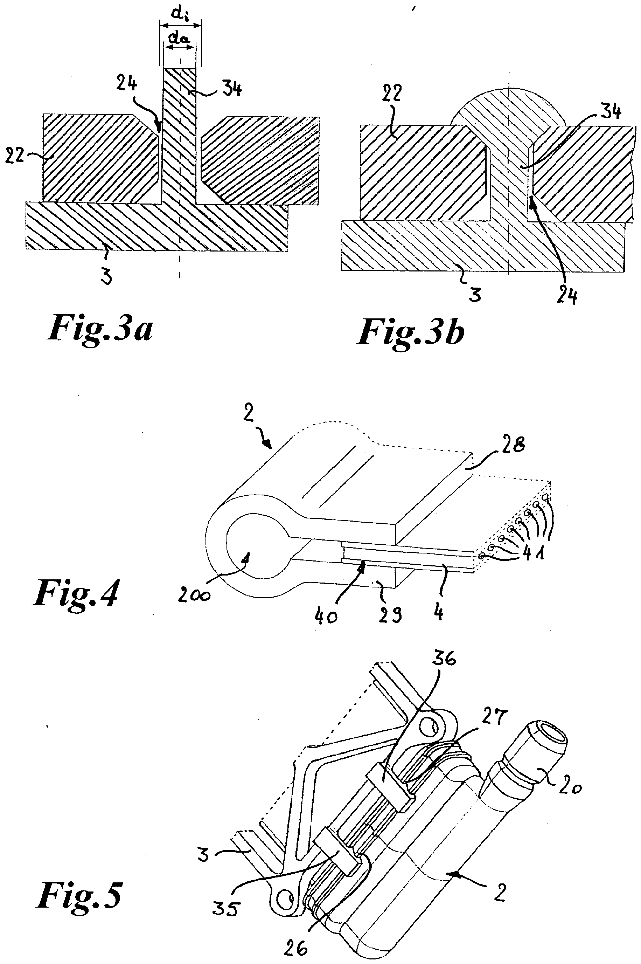

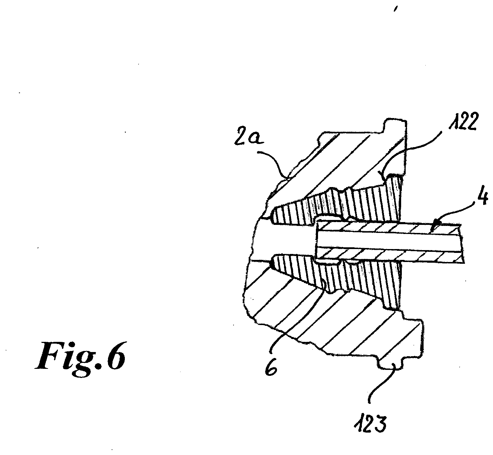

Die beiden Verteilerelemente 2a und 2b sind als Gleichteile ausgebildet und eines davon in Figur 2 perspektivisch dargestellt (hier das Verteilerelement 2a). Wie dieser entnommen werden kann, weisen die Verteilerelemente 2 bzw. 2a, 2b jeweils ein Anschlussprofil 20, hier in Figur 2 beispielsweise als Dornprofil ausgebildet, auf. Über das Anschlussprofil 20 kann das jeweilige Verteilerelement 2, 2a und 2b bzw. dementsprechend auch die Wärmetauscher-Einheit 1 mit einer jeweiligen Medienzuleitung und Medienableitung verbunden werden, die in den Figuren 1 und 2 nicht gezeigt ist. Hierüber ist ein Zulauf und ein Ablauf von Wärmetauschermedium möglich. Das Wärmetauschermedium durchströmt nach dem Eintritt in die Verteilerelemente 2, 2a und 2b Kanäle des Wärmetauscherelementes 4. Dementsprechend strömt das Wärmetauschermedium durch eines der beiden Verteilerelemente ein, durchströmt das Wärmetauscherelement 4 und strömt durch das andere Verteilerelement wieder aus der Wärmetauscher-Einheit hinaus. Zum Verbinden der beiden Verteilerelemente 2, 2a und 2b mit dem Wärmetauscherelement 4 weisen diese dementsprechend einen Aufnahmeabschnitt 21 auf, der kappenartig länglich mit einer großen Eintrittsöffnung ausgebildet ist. In diesen Aufnahmeabschnitt 21 wird das Wärmetauscherelement 4 mit seinen Längsseiten, an denen die das Wärmetauscherelement 4 durchdringenden Kanäle austreten, verbunden. Um einen ungewollten Austritt von Wärmetauschermedium in dem Übergangsbereich von Wärmetauscherelement 4 auf die jeweiligen Verteilerelemente 2, 2a und 2b sicher vermeiden zu können, können in diesem Bereich Dichtungen 6 angeordnet werden. Diese können insbesondere als Elastomer-Dichtung ausgebildet und radial zwischen Wärmetauscherelement 4 und Verteilerelement 2, 2a, 2b im Bereich von dessen Aufnahmeabschnitt 21 angeordnet sein. Ebenfalls ist es grundsätzlich möglich, die Verteilerelemente 2, 2a und 2b an das Wärmetauscherelement 4 anzuspritzen, anzukleben oder heiß zu verstemmen. Die Möglichkeit des Verklebens wird unter Bezug auf Figur 4 weiter unten beschrieben. In Figur 6 ist eine Querschnittsansicht durch das Verteilerelement 2a mit darin eingefügtem Dichtungselement 6 gezeigt. Dies ist in das Verteilerelement 2a formschlüssig aufgenommen. Das Verteilerelement 2a weist einen umlaufenden inneren Anschlag 122 für das Dichtungselement 6 ebenso wie ein außenseitiges Anschlagselement 123 zum seitlichen Anschlag des thermoelektrischen Elements 5 auf. In das Dichtungselement 6 ist das Wärmetauscherelement 4 eingefügt und wird darin dichtend gehalten bzw. aufgenommen.

Das Wärmetauscherelement 4 besteht insbesondere aus Aluminium und kann beispielsweise als Strangpressprofil hergestellt werden. Hierdurch ist einerseits das Einbringen der gewünschten Kanäle in das Wärmetauscherelement zum Hindurchströmen von Wärmetauschermedium sehr gut möglich. Ferner kann eine sehr gute Wärmeübertragung auch bei geringen Volumenströmen des durch die Kanäle des Wärmetauscherelements 4 strömenden Wärmetauschermediums und somit eine laminare Strömung sichergestellt werden. Die Verteilerelemente 2, 2a und 2b bestehen demgegenüber insbesondere aus einem thermoplastischen Kunststoff mit geringer Wärmeleitfähigkeit, um im Bereich der Verteilerelemente 2, 2a und 2b Wärmeverluste so weit wie möglich zu minimieren. Beispielsweise können die Verteilerelemente 2a und 2b aus glas- oder kohlefasergefüllten Thermoplasten, insbesondere POM, PP oder PPA hergestellt werden. Da die Verteilerelemente 2, 2a und 2b von Wärmetauschermedium durchströmt werden, kann bei einer solchen Materialwahl eine ausreichend hohe Beständigkeit gegen Wasser und Glykol bei einer guten Formbeständigkeit des Materials sichergestellt werden.

Wie Figur 2 weiter entnommen werden kann, weisen die Verteilerelemente 2, 2a bzw. 2b jeweils insbesondere zwei Verbindungsabschnitte 22, 23 auf, über die die Verteilerelemente mit dem Halterahmen 3 verbunden werden können. Die beiden in Figur 2 gezeigten Verbindungsabschnitte sind als flache Zungen ausgebildet, die endseitig jeweils mit einer Durchgangsöffnung 24 bzw. 25 versehen sind. Diese werden zum Heißvernieten mit dem Halterahmen verwendet. Der Vorgang des Heißvernietens von Halterahmen 3 und Verteilerelement 2 bzw. 2a bzw. 2b erfolgt wie in den Figuren 3a und 3b angedeutet. Der Halterahmen 3 weist zum Heißvernieten mit dem jeweiligen Verteilerelement 2, 2a bzw. 2b vorkragende Stifte 34 auf. Der jeweilige vorkragende Stift 34 wird durch die jeweilige Durchgangsöffnung 24 bzw. 25 der zungenförmigen Verbindungsabschnitte 22, 23 der jeweiligen Verteilerelemente 2, 2a und 2b hindurchgeführt. Dies ist in Figur 3a gezeigt. Zum Erzeugen eines Formschlusses wird ein Teil des vorkragenden Stiftes 34 aufgeschmolzen und füllt dabei einen Teil der konisch zulaufenden Durchgangsöffnung 24 bzw. 25 formschlüssig aus, wie dies Figur 3b entnommen werden kann. Die konisch zulaufende Formgebung der jeweiligen Durchgangsöffnung 24 bzw. 25 ist Figur 3a, jedoch auch Figur 3b zu entnehmen. Durch das Heißvernieten von Halterahmen 3 und dem jeweiligen Verteilerelement 2a bzw. 2b wird somit eine formschlüssige Verbindung, die jedoch keinen Stoffschluss bedingt, erzeugt. Hierdurch werden Halterahmen 3 und Verteilerelement 2, 2a bzw. 2b fest aneinander gehalten. Halterahmen 3 und Verteilerelement 2, 2a bzw. 2b können somit aus unterschiedlichen Werkstoffen bestehen und dementsprechend die Werkstoffauswahl für Halterahmen und Verteilerelemente an deren jeweilige Funktion angepasst werden. Durch das Aufschmelzen des vorkragenden Stiftes 34 zum Erzeugen des Formschlusses ist keine Doppelpassung erforderlich, da die jeweiligen zungenförmigen Verbindungsabschnitte 22, 23 der Verteilerelemente 2, 2a, 2b eben flächig an dem Halterahmen 3 anliegen, wie Figur 3a und 3b zu entnehmen ist, und somit auch bei Innendruckbelastung der Verteilerelemente 2, 2a, 2b durch dort hindurchströmendes Wärmetauschermedium eine sichere Verbindung geschaffen werden kann, die ein Verdrehen bzw. Verschieben von Halterahmen und jeweiligem Verteilerelement 2a, 2b gegeneinander unterbindet. Der jeweilige vorkragende Stift 34 an dem Halterahmen 3 weist, wie dies Figur 3a und Figur 3b entnommen werden kann, einen geringeren Außendurchmesser dₐ auf als dem Innendurchmesser dⱼ der jeweiligen Durchgangsöffnung 24 bzw. 25 entspräche.

Anstelle eines Heißvernietens von Halterahmen 3 und Verteilerelement 2, 2a bzw. 2b können beide auch kraftschlüssig, beispielsweise über ein Verrasten miteinander verbunden werden. Dies ist beispielhaft in Figur 5 gezeigt. Hierbei sind an dem Halterahmen 3 zwei Rasthaken 35, 36 angeordnet, die in entsprechende Rastaufnahmen 26, 27 an dem hier gezeigten Verteilerelement 2 eingreifen und darin verrasten. Eine solche Verbindung zwischen Halterahmen 3 und Verteilerelement 2 kann je nach Ausgestaltung der Verrastung ggf. sogar wieder gelöst werden.

Wie Figur 5 noch weiter entnommen werden kann, ist das Anschlussprofil 20 des Verteilerelements 2 hier nicht als Dornprofil, sondern dornloses Steckverbinderprofil ausgebildet. In dieses dornlose Steckverbinderprofil kann insbesondere eine Medienleitung zum Transport von Wärmetauschermedium eingesteckt werden und darin verrasten.

Eine verrastende Verbindung insbesondere in Form von Schnapphaken bzw. Rasthaken kann alternativ zu der in Figur 5 gezeigten zwischen Halterahmen 3 und Verteilerelement 2 beispielsweise auch durch Eingreifen von an dem Halterahmen 3 angeordneten Rasthaken in entsprechende Öffnungen, die in vorkragenden Abschnitten des Verteilerelementes 2 angeordnet sind, vorgesehen werden. Ebenfalls ist es möglich, mit Rasthaken versehene Elemente an den Halterahmen 3 vorzusehen, die einen Abschnitt des jeweiligen Verteilerelementes 2 übergreifen und um diesen herumgreifend an diesem verrasten. Es sind ferner auch noch andere Arten eines Verrastens von Halterahmen 3 und Verteilerelement 2 aneinander möglich. Dementsprechend kann die für den jeweiligen Anwendungsfall geeignete Verbindungsmöglichkeit zwischen Halterahmen 3 und Verteilerelement 2 ausgewählt werden.

Wie Figur 4 entnommen werden kann, kann das Verteilerelement 2 mit dem Wärmetauscherelement 4 durch Verkleben verbunden werden. Das Verteilerelement 2 weist hierbei zwei sich etwa parallel erstreckende Verbindungsabschnitte 28, 29 des jeweiligen Aufnahmeabschnitts 21 auf. Ein randseitiger Abschnitt 40 des Wärmetauscherelementes 4 wird zwischen die beiden Verbindungsabschnitte 28, 29 eingefügt und dort verklebt. Dies ist in Figur 4 angedeutet. Dementsprechend stehen die in Figur 4 ebenfalls angedeuteten, sich durch das Wärmetauscherelement 4 hindurch erstreckenden Kanäle 41 in Strömungsverbindung mit dem inneren Durchströmungsraum 200 des Verteilerelementes 2. Das Vorsehen einer solchen Klebeverbindung von Wärmetauscherelement 4 und Verteilerelement 2 eignet sich besonders dann, wenn das Verteilerelement 2 aus Polyamid besteht. Sollen demgegenüber Wärmetauscherelement 4 und Verteilerelement 2 durch Heißverstemmen miteinander verbunden werden, wird vorteilhaft die Oberfläche des aus Aluminium bestehenden Wärmetauscherelementes 4 zuvor aufgeraut, um ein Heißverstemmen mit dem Kunststoffmaterial des Verteilerelementes 2 zu ermöglichen.

Das Verteilerelement 2 gemäß Figur 2 weist im Bereich seines Aufnahmeabschnitts 21 ferner ebenfalls ein Anschlagselement 121 zum Anschlag des Dichtungselements 6 im Verteilerelement 2 auf. Beim Zusammenbau der einzelnen Komponenten der Wärmetauscher-Einheit 1 ist hierüber eine einfache und sehr gute Positionierung des thermoelektrischen Elementes 5 in Bezug auf die übrigen Komponenten insbesondere das Verteilerelement bzw. die Verteilerelemente 2 möglich.

Ferner können die Verteilerelemente 2 bzw. 2a bzw. 2b Einrichtungen zur Steuerung der Strömung des Wärmetauschermediums innerhalb von diesen aufweisen, insbesondere Stege, Staubalken etc. Gerade im Bereich des inneren Durchströmungsraums 200, der im perspektivischen Schnitt in Figur 4 gezeigt ist, aber auch im Bereich des Übergangs zu dem jeweiligen Anschlussprofil 20 des jeweiligen Verteilerelementes können derartige Einrichtungen zur Strömungssteuerung vorgesehen werden, um die Strömung optimal auf die Kanäle 41 des Wärmetauscherelementes 4 zu verteilen. In Figur 4 ist allerdings keine solche Einrichtung zur Strömungssteuerung gezeigt.

Um die für die Stromversorgung des thermoelektrischen Elementes 5, insbesondere Peltier-Elementes, erforderlichen elektrischen Zuleitungen 8, 9 beschädigungssicher und gegen Zugbelastung geschützt, an der Wärmetauscher-Einheit 1 anzuordnen, weist der Halterahmen 3 zumindest eine Halterungs- und/oder Führungseinrichtung 7 zum Halten und/oder Führen der elektrischen Zuleitungen 8, 9 des thermoelektrischen Elementes 5 auf. Bei der Ausgestaltung nach Figur 1 wird eine solche Halterungs- und/oder Führungseinrichtung 7 für elektrische Zuleitungen 8, 9 durch einen der Verbindungstege des Halterahmens 3 gebildet. Es kann jedoch auch eine andere Ausgestaltung einer solchen Halterungs- und/oder Führungseinrichtung 7 für die elektrischen Zuleitungen 8, 9 am Halterahmen 3 vorgesehen werden.

Neben den im Vorstehenden beschriebenen und in den Figuren gezeigten Ausführungsvarianten von Wärmetauscher-Einheiten können noch zahlreiche weitere gebildet werden, insbesondere auch beliebige Kombinationen der vorstehend beschriebenen Merkmale von diesen, wobei die jeweilige Wärmetauscher-Einheit zumindest ein thermoelektrisches Element, wie insbesondere ein Peltier-Element, zumindest ein Wärmetauscherelement zum Wärmetausch mit dem thermoelektrischen Element und zumindest ein Verteilerelement zum Zu- und Abführen eines Wärmetauschermediums umfasst, wobei ferner zumindest ein Halterahmen zum Halten des zumindest einen Wärmetauscherelementes und des zumindest einen thermoelektrischen Elementes, das insbesondere anliegend an dem Wärmetauscherelement angeordnet sind, vorgesehen ist, und wobei ferner das zumindest eine Verteilerelement mit dem zumindest einen Wärmetauscherelement und mit dem zumindest einen Halterahmen verbunden ist oder werden kann.

### Bezugszeichenliste

- 1: Wärmetauscher-Einheit
- 2: Verteilerelement
- 2a: Verteilerelement
- 2b: Verteilerelement
- 3: Halterahmen
- 4: Wärmetauscherelement
- 5: thermoelektrisches Element
- 6: Dichtungselement
- 7: Halterungs- und/oder Führungseinrichtung
- 8: elektrische Zuleitung
- 9: elektrische Zuleitung
- 20: Anschlussprofil
- 21: Aufnahmeabschnitt
- 22: Verbindungsabschnitt
- 23: Verbindungsabschnitt
- 24: Durchgangsöffnung
- 25: Durchgangsöffnung
- 26: Rastaufnahme
- 27: Rastaufnahme
- 28: Verbindungsabschnitt
- 29: Verbindungsabschnitt
- 30: Öffnung
- 31: Öffnung
- 32: Öffnung
- 33: Öffnung
- 34: vorkragender Stift
- 35: Rasthaken
- 38: Rasthaken
- 37: Verbindungssteg
- 38: Verbindungssteg
- 39: Verbindungssteg
- 40: randseitiger Abschnitt
- 41: Kanal
- 121: Anschlagselement
- 122: Anschlag
- 123: Anschlagselement
- 200: innerer Durchströmungsraum
- dₐ: Außendurchmesser von 34
- dᵢ: Innendurchmesser von 24/25

## Patentansprüche

1. Wärmetauscher-Einheit (1), umfassend zumindest ein thermoelektrisches Element (5), insbesondere ein Peltier-Element, zumindest ein Wärmetauscherelement (4) zum Wärmetausch mit dem thermoelektrischen Element (5) und zumindest ein Verteilerelement (2, 2a, 2b) zum Zuführen und Abführen eines das zumindest eine Wärmetauscherelement (4) durchströmenden Wärmetauschermediums,
**dadurch gekennzeichnet, dass**
zumindest ein Halterahmen (3) zum Halten zumindest des zumindest einen Wärmetauscherelements (4) und des zumindest einen thermoelektrischen Elements (5) vorgesehen ist, wobei das zumindest eine Verteilerelement (2, 2a, 2b) mit dem zumindest einen Wärmetauscherelement (4) und mit dem zumindest einen Halterahmen (3) verbindbar oder verbunden ist.

2. Wärmetauscher-Einheit (1) nach Anspruch 1,
**dadurch gekennzeichnet, dass**
das Wärmetauscherelement (4) aus einem Werkstoff mit sehr hoher Wärmeleitfähigkeit besteht, insbesondere aus Aluminium, insbesondere das Wärmetauscherelement (4) als Strangpressprofil aus Aluminium ausgebildet ist.

3. Wärmetauscher-Einheit (1) nach Anspruch 1 oder 2,
**dadurch gekennzeichnet, dass**
der Halterahmen (3) als Rippenstruktur ausgebildet ist.

4. Wärmetauscher-Einheit (1) nach einem der vorstehenden Ansprüche,
**dadurch gekennzeichnet, dass**
der Halterahmen (3) aus zumindest einem hoch kriechbeständigen Kunststoffmaterial zur Gewichtsminimierung und Sicherstellung einer Kraftübertragung beim Verbinden mit dem thermoelektrischen Element (5) besteht, insbesondere aus zumindest einem glas- oder kohlefasergefüllten Thermoplasten oder Duroplasten.

5. Wärmetauscher-Einheit (1) nach einem der vorstehenden Ansprüche,
**dadurch gekennzeichnet, dass**
das zumindest eine Verteilerelement (2, 2a, 2b) endseitig mit zumindest einem Anschlussprofil (20) zum Anschließen an zumindest eine Medienleitung versehen ist.

6. Wärmetauscher-Einheit (1) nach einem der vorstehenden Ansprüche,
**dadurch gekennzeichnet, dass**
das zumindest eine Verteilerelement (2, 2a, 2b) aus zumindest einem Material mit geringer Wärmeleitfähigkeit zum Minimieren von Wärmeverlusten besteht, insbesondere aus zumindest einem thermoplastischen Kunststoffmaterial.

7. Wärmetauscher-Einheit (1) nach einem der vorstehenden Ansprüche,
**dadurch gekennzeichnet, dass**
das zumindest eine Verteilerelement (2, 2a, 2b) mit dem zumindest einen Halterahmen (3) durch formschlüssige Verbindung, insbesondere durch Heißvernieten, Verrasten, verbindbar oder verbunden ist.

8. Wärmetauscher-Einheit (1) nach einem der vorstehenden Ansprüche,
**dadurch gekennzeichnet, dass**
zwei Verteilerelemente (2, 2a, 2b) als Gleichteile ausgebildet und mit dem Halterahmen (3) verbindbar oder verbunden sind zum Vorsehen eines Wärmetauschermedium-Einlaufs und eines Wärmetauschermedium-Auslaufs.

9. Wärmetauscher-Einheit (1) nach einem der vorstehenden Ansprüche,
**dadurch gekennzeichnet, dass**
das zumindest eine Wärmetauscherelement (4) durch Vorsehen zumindest eines Dichtelements (6), insbesondere eines radial wirkenden Dichtelements, gegenüber dem zumindest einen Verteilerelement (2, 2a, 2b) abdichtbar oder abgedichtet ist.

10. Wärmetauscher-Einheit (1) nach einem der Ansprüche 1 bis 8,
**dadurch gekennzeichnet, dass**
das zumindest eine Wärmetauscherelement (4) und das zumindest eine Verteilerelement (2, 2a, 2b) stoffschlüssig und/oder kraftschlüssig miteinander verbunden sind, insbesondere durch Anspritzen, Kleben oder Heißverstemmen des zumindest einen Verteilerelements (2, 2a, 2b) an dem zumindest einen Wärmetauscherelement (4).

11. Wärmetauscher-Einheit (1) nach einem der vorstehenden Ansprüche,
**dadurch gekennzeichnet, dass**
das zumindest eine Verteilerelement (2, 2a, 2b) zumindest ein Anschlagselement (121) zum Vorsehen eines Anschlags bei der Positionierung des thermoelektrischen Elements (5) an diesem aufweist.

12. Wärmetauscher-Einheit (1) nach einem der vorstehenden Ansprüche,
**dadurch gekennzeichnet, dass**
der zumindest eine Halterahmen (3) mit zumindest einer Halterungs- und/oder Führungseinrichtung (7) zum Halten und/oder Führen zumindest einer elektrischen Zuleitung (8, 9) des thermoelektrischen Elements (5) versehen ist.

13. Wärmetauscher-Einheit (1) nach einem der vorstehenden Ansprüche,
**dadurch gekennzeichnet, dass**
das zumindest eine Verteilerelement (2, 2a, 2b) mit zumindest einer Einrichtung zur Strömungssteuerung versehen ist zum Steuern der Strömung des Wärmetauschermediums in Kanäle (41) des Wärmetauscherelements (4) hinein und aus diesen heraus in das zumindest eine Verteilerelement (2, 2a, 2b) hinein.

## Claims

1. Heat exchanger unit (1), comprising at least one thermoelectric element (5), in particular a Peltier element, at least one heat exchanger element (4) for heat exchange with the thermoelectric element (5), and at least one distributor element (2, 2a, 2b) for supplying and conveying away a heat exchanger medium flowing through the at least one heat exchanger element (4),
**characterised in that**
at least one holding frame (3) for holding at least the at least one heat exchanger element (4) and the at least one thermoelectric element (5) is provided, wherein the at least one distributor element (2, 2a, 2b) can be connected or is connected to the at least one heat exchanger element (4) and to the at least one holding frame (3).

2. Heat exchanger unit (1) according to claim 1,
**characterised in that**
the heat exchanger element (4) consists of a material with very high thermal conductivity, in particular of aluminium, in particular the heat exchanger element (4) is in the form of an extruded section of aluminium.

3. Heat exchanger unit (1) according to claim 1 or 2,
**characterised in that**
the holding frame (3) is in the form of a rib structure.

4. Heat exchanger unit (1) according to any one of the preceding claims,
**characterised in that**
the holding frame (3) consists of at least a highly creep-resistant plastics material for minimising weight and ensuring force transmission on connection to the thermoelectric element (5), in particular of at least a glass- or carbon-fibre-filled thermoplastic or thermosetting plastic.

5. Heat exchanger unit (1) according to any one of the preceding claims,
**characterised in that**
the at least one distributor element (2, 2a, 2b) is provided at the end with at least one connection profile (20) for connection to at least one media line.

6. Heat exchanger unit (1) according to any one of the preceding claims,
**characterised in that**
the at least one distributor element (2, 2a, 2b) consists of at least one material with low thermal conductivity in order to minimise heat losses, in particular of at least one thermoplastic plastics material.

7. Heat exchanger unit (1) according to any one of the preceding claims,
**characterised in that**
the at least one distributor element (2, 2a, 2b) can be connected or is connected to the at least one holding frame (3) by a positive connection, in particular byhot riveting, interlocking.

8. Heat exchanger unit (1) according to any one of the preceding claims,
**characterised in that**
two distributor elements (2, 2a, 2b) are in the form of identical parts and can be connected or are connected to the holding frame (3) in order to provide a heat exchanger medium inlet and a heat exchanger medium outlet.

9. Heat exchanger unit (1) according to any one of the preceding claims,
**characterised in that**
the at least one heat exchanger element (4) can be sealed or is sealed with respect to the at least one distributor element (2, 2a, 2b) by the provision of at least one sealing element (6), in particular of a radially acting sealing element.

10. Heat exchanger unit (1) according to any one of claims 1 to 8,
**characterised in that**
the at least one heat exchanger element (4) and the at least one distributor element (2, 2a, 2b) are connected together by a material-bonded and/or frictional connection, in particular by moulding, adhesive bonding or heat staking of the at least one distributor element (2, 2a, 2b) onto the at least one heat exchanger element (4).

11. Heat exchanger unit (1) according to any one of the preceding claims,
**characterised in that**
the at least one distributor element (2, 2a, 2b) has at least one stop element (121) for providing a stop on positioning of the thermoelectric element (5) thereon.

12. Heat exchanger unit (1) according to any one of the preceding claims,
**characterised in that**
the at least one holding frame (3) is provided with at least one holding and/or guiding device (7) for holding and/or guiding at least one electrical supply line (8, 9) of the thermoelectric element (5).

13. Heat exchanger unit (1) according to any one of the preceding claims,
**characterised in that**
the at least one distributor element (2, 2a, 2b) is provided with at least one device for flow control for controlling the flow of the heat exchanger medium into channels (41) of the heat exchanger element (4) and out of those channels into the at least one distributor element (2, 2a, 2b).

## Revendications

1. Ensemble d'échangeur de chaleur (1) comprenant au moins un élément thermoélectrique (5), en particulier un élément Peltier, au moins un élément échangeur de chaleur (4) pour l'échange de chaleur avec l'élément thermoélectrique (5) et au moins un élément de distribution (2, 2a, 2b) pour alimenter et décharger un milieu d'échange de chaleur s'écoulant à travers le au moins un élément échangeur de chaleur (4),
**caractérisé en ce qu'**au moins un cadre de maintien (3) pour maintenir au moins le au moins un élément échangeur de chaleur (4) et le au moins un élément thermoélectrique (5) est prévu, le au moins un élément de distribution (2, 2a, 2b) pouvant être connecté ou étant connecté avec le au moins un élément échangeur de chaleur (4) et avec le au moins un cadre de maintien (3).

2. Ensemble d'échangeur de chaleur (1) selon la revendication 1, **caractérisé en ce que** l'élément échangeur de chaleur (4) est constitué d'un matériau à conductivité thermique très élevée, en particulier l'aluminium, en particulier l'élément échangeur de chaleur (4) est réalisé sous la forme d'un profilé en aluminium extrudé.

3. Ensemble d'échangeur de chaleur (1) selon la revendication 1 ou 2, **caractérisé en ce que** le cadre de maintien (3) est conçu comme une structure nervurée.

4. Ensemble d'échangeur de chaleur (1) selon l'une des revendications précédentes, **caractérisé en ce que** le cadre de maintien (3) est constitué d'au moins une matière plastique hautement résistante au fluage pour minimiser le poids et assurer la transmission de puissance lors de la connexion à l'élément thermoélectrique (5), en particulier d'au moins un thermoplastique ou thermodurcissable chargé de fibre de verre ou de carbone.

5. Ensemble d'échangeur de chaleur (1) selon l'une des revendications précédentes, **caractérisé en ce que** le au moins un élément de distribution (2, 2a, 2b) est pourvu à l'extrémité d'au moins un profil de connexion (20) pour la connexion à au moins une ligne de media.

6. Ensemble d'échangeur de chaleur (1) selon l'une des revendications précédentes, **caractérisé en ce que** le au moins un élément de distribution (2, 2a, 2b) est constitué d'au moins un matériau à faible conductivité thermique afin de minimiser les pertes thermiques, en particulier d'au moins un matériau thermoplastique.

7. Ensemble d'échangeur de chaleur (1) selon l'une des revendications précédentes, **caractérisé en ce que** le au moins un élément de distribution (2, 2a, 2b) peut être ou est relié à l'au moins un cadre de maintien (3) au moyen d'une liaison à emboîtement, notamment par rivetage à chaud, verrouillage.

8. Ensemble d'échangeur de chaleur (1) selon l'une des revendications précédentes, **caractérisé en ce que** deux éléments de distribution (2, 2a, 2b) sont conçus comme des pièces identiques et peuvent être ou sont reliés au cadre de maintien (3) afin de fournir une entrée de milieu d'échange de chaleur et une sortie de milieu d'échange de chaleur.

9. Ensemble d'échangeur de chaleur (1) selon l'une des revendications précédentes, **caractérisé en ce que** le au moins un élément échangeur de chaleur (4) peut être scellé ou est scellé à l'au moins un élément de distribution (2, 2a, 2b) en prévoyant au moins un élément d'étanchéité (6), en particulier un élément d'étanchéité à action radiale.

10. Ensemble d'échangeur de chaleur (1) selon l'une des revendications 1 à 8, **caractérisé en ce que** le au moins un élément échangeur de chaleur (4) et le au moins un élément de distribution (2, 2a, 2b) sont reliés l'un à l'autre matériellement et / ou de manière non positive, notamment par moulage, collage ou calfeutrage à chaud de l'au moins un élément de distribution (2, 2a, 2b) sur l'au moins un élément échangeur de chaleur (4).

11. Ensemble d'échangeur de chaleur (1) selon l'une des revendications précédentes, **caractérisé en ce que** le au moins un élément distributeur (2, 2a, 2b) comporte au moins un élément d'arrêt (121) pour fournir une butée lorsque l'élément thermoélectrique (5) est positionné sur celui-ci.

12. Ensemble d'échangeur de chaleur (1) selon l'une des revendications précédentes, **caractérisé en ce que** l'au moins un cadre de maintien (3) est pourvu d'au moins un dispositif de maintien et / ou de guidage (7) pour maintenir et / ou guider au moins un conducteur électrique (8, 9) de l'élément thermoélectrique (5).

13. Ensemble d'échangeur de chaleur (1) selon l'une des revendications précédentes, **caractérisé en ce que** l'au moins un élément de distribution (2, 2a, 2b) est pourvu d'au moins un dispositif de régulation de débit pour contrôler l'écoulement du milieu d'échange de chaleur dans les canaux (41) de l'élément échangeur de chaleur (4) dans et hors de ceux-ci, dans l'au moins un élément de distribution (2, 2a, 2b).
